# EUROPEAN PATENT SPECIFICATION

(11) **EP 2 128 736 B1**
(45) Date of publication and mention of the grant of the patent: **13.07.2016**
(21) Application number: 08704100.0
(22) Date of filing: 29.01.2008
(51) Int. Cl.: G05F 1/56, H02M 3/00

(54) **ELECTRONIC CIRCUIT DEVICE**
ELEKTRONISCHE SCHALTUNGSANORDNUNG
DISPOSITIF DE CIRCUIT ÉLECTRONIQUE

(30) Priority: 29.03.2007 JP 2007089951
(43) Date of publication of application: 02.12.2009
(73) Proprietor: Kyushu Institute of Technology, Kitakyushu-shi, Fukuoka 804-8550 (JP)
(72) Inventor: MORIMOTO, Hiroyuki, Miyazaki 880-2113 (JP); NAKAMURA, Kazuyuki, Fukuoka 820-8502 (JP)
(74) Representative: Gulde & Partner
(86) International application number: PCT/JP2008/051318
(87) International publication number: WO 2008/120488

(56) References cited:
- WO-A1-90/06633
- JP-A- 01 171 008
- JP-A- 06 086 540
- JP-A- 2003 348 826
- JP-A- 2006 170 898
- JP-A- 2007 258 294
- US-A- 4 658 201
- US-A- 5 615 058
- US-A- 5 684 828
- US-A- 5 717 654
- US-A- 5 994 884
- US-A1- 2002 176 199
- "LM317M 3-Terminal Adjustable Regulator" Texas Instruments 31 July 2006 (2006-07-31), XP002584356 Retrieved from the Internet: URL:http://focus.tij.co.jp/jp/lit/ds/symli nk/lm317m.pdf> [retrieved on 2010-05-27]

## Description

### Technical Field

The present invention relates to electronic circuit devices, particularly, devices such as three-terminal regulators and crystal oscillators and, in particular, to an electronic circuit device that allows the function thereof to be freely set in accordance with externally input data.

### Background Art

Three-terminal electronic circuit devices, such as three-terminal regulators and crystal oscillators, are widely used in various electronic circuits. In such a three-terminal electronic circuit device, a functional circuit mounted on an IC chip or the like is sealed by a resin mold or a package made of ceramic or the like and is connected to an external circuit through three leads. The functional circuit sealed by mold material cannot be accessed through any element other than the three leads, thus making it difficult to adjust a characteristic of the functional circuit. Thus, in general, an externally attached circuit for providing a necessary characteristic is employed or another terminal (a terminal that becomes unusable after sealing with the package) for adjustment is used before sealing with the package to write adjustment data.

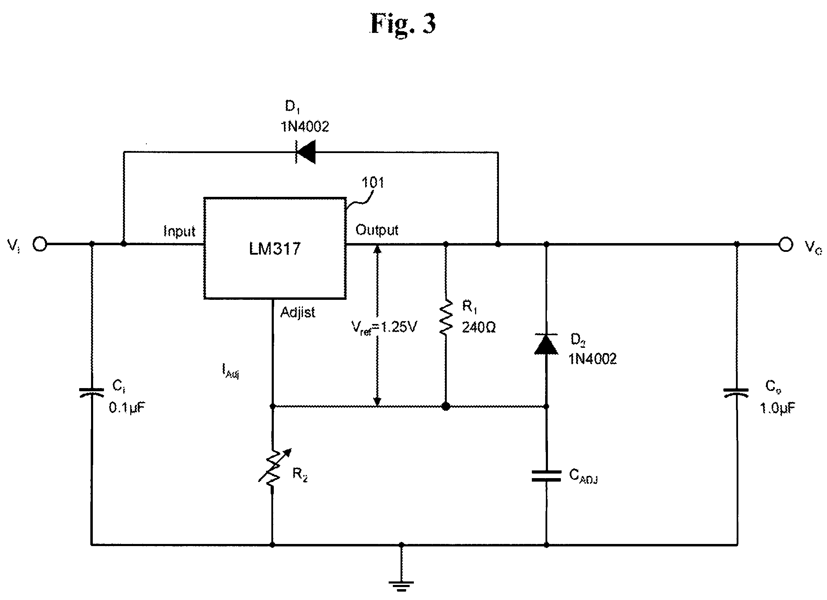

For example, in a three-terminal 500 mA adjustable positive-voltage regulator 101 described in Non-Patent Document 1, an external circuit as shown in Fig. 3 is used to adjust an output voltage Vₒ. In the circuit of Fig. 3, the output voltage Vₒ can be adjusted using a variable resistor R₂ and the value of Vₒ is expressed as Vₒ = V_{ref}(1+R₂/R₁)+(I_{Adj}·R₂).

### [Non-Patent Document 1]

Texas Instrument Incorporated, "LM317M 3-TERMINAL ADJUSTABLE REGULATOR", [online], in 2000, Texas Instrument Incorporated, searched on March 27, 2007, Internet <URL: http://focus.tij.co.jp/jp/lit/ds/symlink/lm317m.pdf>, p. 7.

### Disclosure of Invention

### Problems to be solved by the Invention

However, when an external circuit is used to adjust the output, an area for mounting the external circuit is required and thus the mounting area increases. Also, the component count also increases, the failure rate of the circuit also increases correspondingly, and the manufacturing cost also increases. On the other hand, in the case of configuration in which an output characteristic is adjusted by another terminal for adjustment before sealing with a package, it is impossible to deal with a case in which an output characteristic needs to be adjusted after the functional circuit is sealed with a package. Also, when an output characteristic is adjusted before sealing with a package, it is necessary to adjust the functional circuit, such as an IC chip, in its bare state while measuring a characteristic thereof. Thus, miscellaneous tasks are required such that dedicated jigs for setting are necessary.

Also, a conceivable method is that an adjustment-dedicated terminal is extracted to the outside of the package through a lead or the like and an adjustment signal is input from the dedicated terminal to adjust the functional circuit. In this case, however, since it is necessary to excessively extract the terminal for adjustment, the mounting area of the package increases and the manufacturing cost also increases.

Accordingly, an object of the present invention is to provide a three-terminal device that can change a characteristic of the functional circuit even after it is sealed with a package and that can achieve a reduction in miscellaneous tasks during characteristic setting, a reduction in cost, a reduction in failure rate, and a reduction in mounting area.

### Means for Solving the Problems

A first configuration for a three-terminal device according to the present invention is disclosed in the appended claim 1.

According to this configuration, when the functional circuit is to be adjusted, the write activation burst is input from the "predetermined terminal". Consequently, the circuit main-unit is put into the input-enable state in which setting data can be input. In this state, setting data is input from the "predetermined terminal" and is stored in the data storing means. The.operation state of the functional circuit is set in accordance with the information of the setting data written to the data storing means. Consequently, it is possible to adjust an output of the functional circuit.

As described above, there is provided the function for permitting data reception by using the write activation burst, during writing of setting data. This does not require a dedicated terminal for inputting the setting data and makes it possible to cause any of the existing terminals (the terminals intrinsically included in the functional circuit) to serve also as a terminal for inputting the setting data.

The "functional circuit" herein refers to a circuit for realizing a function that is essentially required by the electronic circuit device. For example, for a switching regulator, an output-voltage generating circuit corresponds to the functional circuit, and for a crystal oscillator, an oscillating circuit corresponds to the functional circuit. As the "prescribed burst signal", for example, a pulse or sinusoidal signal having a prescribed frequency, a pulse signal having a prescribed pattern, or the like can be used. The "setting data" refers to data for setting the operation state of the functional circuit.

A second configuration for the electronic circuit device of the present invention is characterized in that, in the first configuration, the data-reception permitting means comprises:
a serial interface for receiving a serial data signal input from the predetermined terminal; and
a signal-pattern detecting circuit for detecting a key pattern signal input from the predetermined terminal, when the burst detecting circuit detects the write activation burst;
wherein when the key pattern signal is detected, the serial interface receives setting data subsequently input from the predetermined terminal and writes the setting data to the data storing means.

According to this configuration, even when a signal that is similar to the write activation burst is input from the "predetermined terminal" as a result of noise, no data is written to the data storing means unless the signal-pattern detecting circuit detects the key pattern signal. Thus, it is possible to effectively prevent functional-circuit malfunction caused by invalid data being written to the data storing means.

A third configuration for the electronic circuit device of the present invention is characterized in that, in the first or second configuration, the data storing means comprises a volatile memory and a nonvolatile memory;
the interface receives the setting data input from the predetermined terminal and writes the setting data to the volatile memory;
a power-supply level determining circuit for outputting a write-enable signal when a level of a power-supply voltage input to a power-supply terminal of the circuit main-unit becomes larger than or equal to a write threshold of the nonvolatile memory and
a nonvolatile-memory writing circuit for writing data, stored in the volatile memory, to the nonvolatile memory, when the write-enable signal is output are provided; and
an operation state of the functional circuit is switched in accordance with information of the setting data written in the volatile memory or the volatile memory.

According to this configuration, the setting data written in the volatile memory is written to the nonvolatile memory, so that the setting of the functional circuit is stored even after the power supply is turned off.

Also, testing of a setting state of the functional circuit is performed in a state in which data is written in the volatile memory. When the output characteristic is a desired characteristic, the level of the power-supply voltage is set to be larger than or equal to the threshold to allow setting data to be written to the nonvolatile memory. As described above, two memories, i.e., the volatile memory and the nonvolatile memory are provided. This makes it possible to make changes to setting at high speed during adjustment of an output characteristic of the functional circuit, makes it possible to store the setting state, and also makes it possible to easily adjust the output characteristic of the functional circuit.

The "write threshold for the nonvolatile memory" has a value that is larger than a typical power-supply voltage and that is smaller than a voltage level required for writing to the nonvolatile memory.

In this case, it is desired that the functional circuit be configured so that the operation state is set to give priority to the setting data written in the volatile memory. This is because rewriting of the volatile memory can be performed at high speed and thus the setting data is written to the volatile memory as a test during adjusting of the output of the functional circuit.

A fourth configuration for the electronic circuit device of the present invention is characterized in that, in any of the first to third configurations, upon receiving the setting data for a predetermined time or corresponding to a predetermined number of bits, the interface re-puts the circuit main-unit into an input-disabled state in which setting data cannot be input.

This configuration makes it possible to effectively avoid an event in which the write-enable state continues for a long time and invalid data is falsely written as a result of noise or the like.

Thus, even for an electronic circuit device having a minimum number of terminals, such as a three-terminal device, it is possible to adjust an output characteristic thereof. Advantages

As described above, according to the present embodiment, the function for permitting data reception by using the write activation burst is provided, and setting data from an existing terminal (a terminal intrinsically included in the functional circuit) is input to perform setting of the functional circuit. This makes it possible to adjust the functional circuit after sealing with a package without having to extract setting-dedicated terminals, the number of which being greater than or equal to the number of terminals of the existing functional circuit, to the outside of the package.

In addition, even for an electronic circuit device having a minimum number of terminals, such as a three-terminal device, it is possible to adjust an output characteristic thereof.

### Brief Description of Drawings

[Fig. 1] Fig. 1 is a block diagram showing the configuration of an electronic circuit device 1 according to a first embodiment of the present invention.
[Fig. 2] Fig. 2 is a diagram showing a voltage level of a power-supply voltage terminal and an input signal of an input and output terminal during setting-data writing operation of the electronic circuit device 1.
[Fig. 3] Fig. 3 is an output-setting changing circuit of an electronic circuit device described in Non-Patent Document 1.

### Reference Numerals

- 1: electronic circuit device
- 2: power supply terminal
- 3: ground terminal
- 4: input and output terminal
- 5: circuit main-unit
- 6: functional circuit
- 7: burst detecting circuit
- 8: serial interface
- 9: signal-pattern detecting circuit
- 10: volatile memory
- 11: nonvolatile memory
- 12: level detecting circuit
- 13: nonvolatile-memory writing circuit

### Best Mode for Carrying Out the Invention

A best mode for carrying out the present invention will be described below with reference to the drawings.

### [First Embodiment]

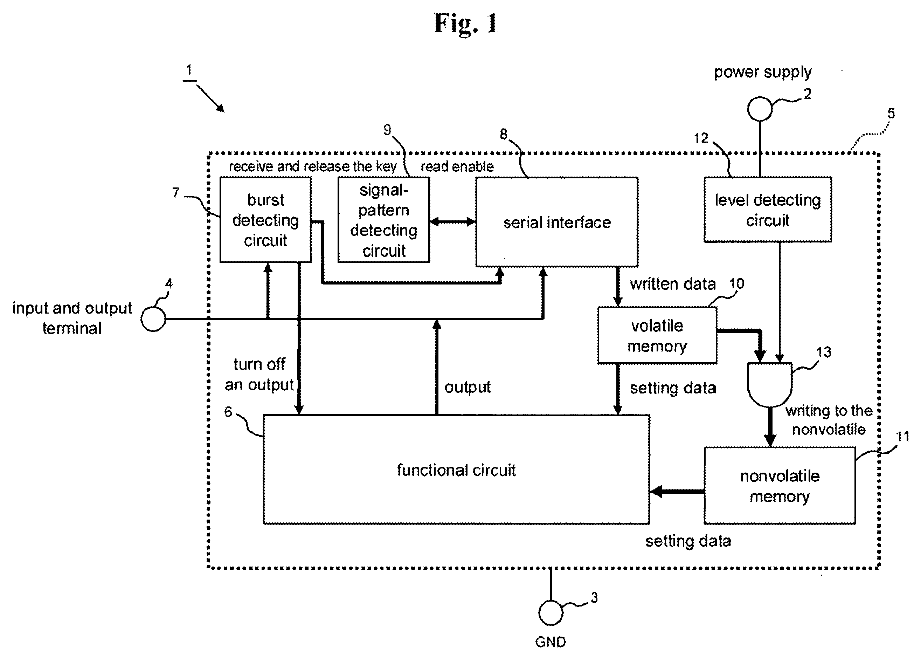

Fig. 1 is a block diagram showing the configuration of an electronic circuit device 1 according to a first embodiment of the present invention.

The electronic circuit device 1 is a three-terminal device having a circuit main-unit 5 mounted on an IC chip and three terminals of a power-supply terminal 2, a ground terminal 3, and an input and output terminal 4. The circuit main-unit 5 is sealed by a resin mold or a package made of ceramic or the like and the power-supply terminal 2, the ground terminal 3, and the input and output terminal 4 are extracted to the outside of the package through leads.

The circuit main-unit 5 is provided with a functional circuit 6, a burst detecting circuit 7, a serial interface 8, a signal-pattern detecting circuit 9, a volatile memory 10, a nonvolatile memory 11, a level detecting circuit 12, and a nonvolatile-memory writing circuit 13.

The functional circuit 6 is a circuit for realizing a function of a power-supply circuit, an oscillating circuit, or the like, the functional being essentially required by the electronic circuit device 1.

The burst detecting circuit 7 is a circuit for detecting a write activation burst input from the input and output terminal 4. The "write activation burst" herein refers to a pulse signal having a prescribed frequency that is longer than or equal to a prescribed time. The serial interface 8 is an interface for receiving a serial signal input from the input and output terminal 4. When the burst detecting circuit 7 detects the write activation burst, the signal-pattern detecting circuit 9 detects a key pattern signal subsequently input from the input and output terminal 4. The volatile memory 10 and the nonvolatile memory 11 are memories for storing setting data received by the serial interface 8. The level detecting circuit 12 is a circuit for outputting a write-enable signal when the level of a power-supply voltage applied to the power-supply terminal 2 becomes larger than or equal to a write threshold of the nonvolatile memory 11. The "write-enable signal" herein is a 1-bit digital signal. When the write-enable signal is "0", this indicates a write-disable state, and when the write-enable signal is "1", this indicates a write-enable state. When the write-enable signal indicates a write-enable state, the nonvolatile-memory writing circuit 13 is a circuit for writing the setting data, stored in the volatile memory 10, to the nonvolatile memory 11.

A description below will be given of the operation of the electronic circuit device 1 of the present embodiment configured as described above.

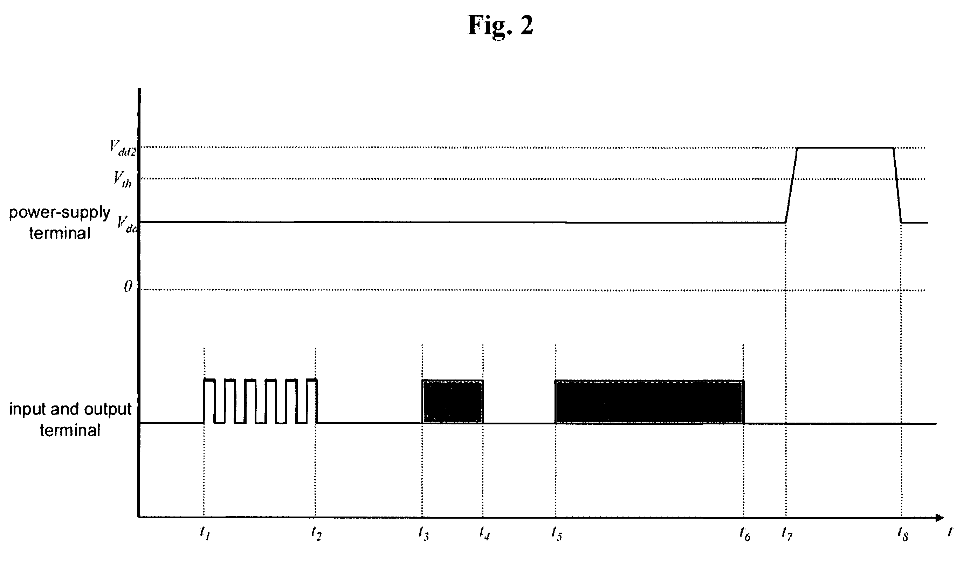

Fig. 2 is a diagram showing a voltage level of the power-supply voltage terminal and an input signal of the input and output terminal during setting-data writing operation of the electronic circuit device 1.

In an initial state, the power-supply voltage applied to the power-supply terminal 4 is a normal power-supply voltage V_{dd}. In this state, a voltage and so on from the functional circuit 6 are output from the input and output terminal 4.

In the initial state, when setting data is written in the nonvolatile memory 11, the functional circuit 6 functions in accordance with the setting data, and when any setting data is not written, the functional circuit 6 functions in a default state.

### (First Example)

For example, in a case in which the functional circuit 6 is a switching regulator circuit, when an output voltage Vₛ is written in the nonvolatile memory 11 as setting data, the functional circuit 6 outputs the voltage Vₛ from the input and output terminal 4. When no setting data is written in the nonvolatile memory 11, the functional circuit 6 outputs a default output voltage Vₒ.
(End of Example)

### (Second Example)

For example, in a case in which the functional circuit 6 is an oscillating circuit, when an oscillation frequency fₛ is written in the nonvolatile memory 11 as setting data, the functional circuit 6 outputs a pulse having the frequency fₛ from the input and output terminal 4. When no setting data is written in the nonvolatile memory 11, the functional circuit 6 outputs a pulse having a default oscillation frequency fₒ.
(End of Example)

First, at time t₁, a pulse signal in a prescribed frequency range is input from the input and output terminal 4 for a prescribed time or more. Consequently, the burst detecting circuit 7 recognizes the input pulse signal as a write activation burst and puts the serial interface 8 into a reception-enable state (hereinafter referred to as a "data reception mode"). Concurrently, an output of the functional circuit 6 is turned off.

In the data reception mode, the serial interface 8 determines whether or not the state is a 0 state or a 1 state on the basis of the pulse width of the pulse input from the input and output terminal 4. The pulse with for the determination criterion is prescribed by an internal time-constant circuit (not shown).

Next, during time t₃ to t₄, a key pattern signal is input from the input and output terminal 4. The serial interface 8 receives the key pattern signal and outputs it to the signal-pattern detecting circuit 9. Upon recognizing that a signal data input from the serial interface 8 is a key pattern signal, the signal-pattern detecting circuit 9 sets the state of the serial interface 8 to a state for performing writing to the volatile memory 10 (hereinafter referred to as a "writing mode").

Proceeding to the writing mode only when the pattern of the signal received by the serial interface 8, the pattern indicating 0 or 1, satisfies a certain condition, as described above, makes it possible to prevent false writing due to noise or the like.

Next, during time t₅ to t₆, setting data is input from the input and output terminal 4. Upon receiving the setting data, the serial interface 8 writes it to the volatile memory 10. Upon receiving setting data having a predetermined length, the serial interface 8 is reset to the reception-disable state again. Also, when the serial interface 8 is reset to the reception-disable state, the output of the functional circuit 6 is turned on again.

On the other hand, when setting data is written to the volatile memory 10, the functional circuit 6 switches the functional state in accordance with the setting data.

### (Third Example)

For example, in a case in which the functional circuit 6 is a switching regulator circuit, when an output voltage Vₛ₁ is written to the volatile memory 10 as setting data, the functional circuit 6 switches the functional state so as to output the voltage Vₛ₁ from the input and output terminal 4 regardless of whether or not setting data is written in the nonvolatile memory 11.
(End of Example)

### (Fourth Example)

For example, in a case in which the functional circuit 6 is an oscillating circuit, when an oscillation frequency fₛ₁ is written to the volatile memory 10 as setting data, the functional circuit 6 outputs a pulse having the frequency fₛ₁ from the input and output terminal 4 regardless of whether or not setting data is written in the nonvolatile memory 11.
(End of Example)

As described above, writing setting data to the volatile memory 10 makes it possible to change the functional state of the functional circuit 6.

Next, during time t₇ to t₈, the level of the power-supply voltage applied to the power-supply terminal 2 is set to a voltage level V_{dd2} required for writing to the nonvolatile memory 11. The level detecting circuit 12 determines that the level of the power-supply voltage becomes larger than the write threshold Vₜₕ, and outputs "1" as the write-enable signal. The "write threshold Vₜₕ" herein has a value that is larger than the normal power-supply voltage V_{dd} and that is smaller than the voltage level V_{dd2} required for writing to the nonvolatile memory 11.

When the write-enable signal becomes "1", the nonvolatile-memory writing circuit 13 outputs the setting data, written in the volatile memory 10, to the nonvolatile memory 11 to perform writing. Consequently, the setting data is non-volatilized, so that the setting data is stored even after the power supply is turned off.

As described above, according to the electronic circuit device 1 of the present embodiment, the function for permitting data reception of the serial interface 8 by using the write activation burst is provided and setting data from the output terminal (the input and output terminal 4) of the functional circuit 6 is input to perform setting of the functional circuit 6. Thus, it is possible to adjust the functional circuit 6 after package sealing without having to extract setting-dedicated terminals, the number of which being greater than or equal to the number of terminals normally required by the functional circuit 6, to the outside of the package.

Also, the two-step setting processing for performing data writing is employed, that is, when the write activation burst is received, the serial interface 8 is put into the data reception mode, and then, when the key pattern signal is received, the serial interface 8 is put into the writing mode. This makes it possible to effectively prevent false writing due to noise or the like.

## Claims

1. A three-terminal device having
a circuit main-unit (5) sealed by mold material and three terminals: a power-supply terminal (2), a ground terminal (3), and an input-and-output terminal (4), that connect the circuit main-unit (5) and an external circuit,
the three-terminal device being **characterized in that**
the circuit main-unit (5) comprises:
a functional circuit (6);
a burst detecting circuit (7) adapted to detect, from a predetermined terminal of any of the three terminals, a write activation burst of a prescribed burst signal having a length that is larger than or equal to a prescribed time;
data-reception permitting means adapted to put the circuit main-unit (5) into an input-enable state in which setting data can be input, when the write activation burst is detected; and
data storing means adapted to store, in the input-enable state, setting data input from the predetermined terminal;
wherein an operation state of the functional circuit (6) is set in accordance with information of the setting data written to the data storing means.

2. The three-terminal device according to claim 1, **characterized in that** the data-reception permitting means comprises:
a serial interface (8) adapted to receive a serial data signal input from the predetermined terminal; and
a signal-pattern detecting circuit (9) adapted to detect a key pattern signal input from the predetermined terminal, when the burst detecting circuit (7) detects the write activation burst;
wherein when the key pattern signal is detected, the serial interface (8) is adapted to receive setting data subsequently input from the predetermined terminal and to write the setting data to the data storing means.

3. The three-terminal device according to claim 1 or 2, **characterized in that**
the data storing means comprises a volatile memory (10) and a nonvolatile memory (11);
the serial interface (8) receives the setting data input from the predetermined terminal and writes the setting data to the volatile memory (10);
a power-supply level determining circuit adapted to output a write-enable signal when a level of a power-supply voltage input to a power-supply terminal (2) of the circuit main-unit (5) becomes larger than or equal to a write threshold of the nonvolatile memory (11) and
a nonvolatile-memory (11) writing circuit adapted to write data, stored in the volatile memory (10), to the nonvolatile memory (11), when the write-enable signal is output are provided; and
said functional circuit (6) is switched the operation state in accordance with information of the setting data written in the volatile memory (10).

4. The three-terminal device according to any of claims 1 to 3, **characterized in that**, upon receiving the setting data for a predetermined time or corresponding to a predetermined number of bits, the serial interface (8) is adapted to reput the circuit main-unit (5) into an input-disabled state in which setting data cannot be input.

## Patentansprüche

1. Dreianschlussvorrichtung mit
einer Schaltungshaupteinheit (5), abgedichtet durch Formmaterial, und
drei Anschlüssen: einem Stromversorgungsanschluss (2), einem Masseanschluss (3) und einem Eingabe-und-Ausgabe-Anschluss (4), die die Schaltungshaupteinheit (5) und eine externe Schaltung verbinden,
wobei die Dreianschlussvorrichtung **dadurch gekennzeichnet ist, dass** die Schaltungshaupteinheit (5) umfasst:
eine Funktionsschaltung (6);
eine Burst-Erfassungsschaltung (7), die so angepasst ist, dass sie, von einem vorgegebenen Anschluss einer der drei Anschlüsse, einen Schreibaktivierungs-Burst eines vorgeschriebenen Burst-Signals mit einer Länge, die größer als oder gleich einer vorgeschriebenen Zeit ist, erfasst;
Datenempfangszulassungsmittel, die so angepasst sind, dass sie die Schaltungshaupteinheit (5) in einen Eingabefreigabezustand versetzen, in dem Einstelldaten eingebbar sind, wenn der Schreibaktivierungs-Burst erfasst ist; und
Datenspeichermittel, die so angepasst sind, dass sie im Eingabefreigabezustand Einstelldaten, eingegeben von dem vorgegebenen Anschluss, speichern;
wobei ein Betriebszustand der Funktionsschaltung (6) gemäß Informationen der Einstelldaten, geschrieben in die Datenspeichermittel, eingestellt ist.

2. Dreianschlussvorrichtung nach Anspruch 1, **dadurch gekennzeichnet, dass** das Datenempfangszulassungsmittel umfasst:
eine serielle Schnittstelle (8), die so angepasst ist, dass sie ein von dem vorgegebenen Anschluss eingegebenes serielles Datensignal empfängt; und
eine Signalmustererfassungsschaltung (9), die so angepasst ist, dass sie ein von dem vorgegebenen Anschluss eingegebenes Schlüsselmustersignal erfasst, wenn die Burst-Erfassungsschaltung (7) den Schreibaktivierungs-Burst erfasst;
wobei, wenn das Schlüsselmustersignal erfasst ist, die serielle Schnittstelle (8) so angepasst ist, dass sie Einstelldaten, anschließend eingegeben von dem vorgegebenen Anschluss, empfängt und die Einstelldaten in die Datenspeichermittel schreibt.

3. Dreianschlussvorrichtung nach Anspruch 1 oder 2, **dadurch gekennzeichnet, dass**
das Datenspeichermittel einen flüchtigen Speicher (10) und einen nichtflüchtigen Speicher (11) umfasst;
die serielle Schnittstelle (8) die Einstelldaten, eingegeben von dem vorgegebenen Anschluss, empfängt und die Einstelldaten in den flüchtigen Speicher (10) schreibt;
eine Stromversorgungspegel-Bestimmungsschaltung, die so angepasst ist, dass sie ein Schreibfreigabesignal ausgibt, wenn ein Pegel einer in einen Stromversorgungsanschluss (2) der Schaltungshaupteinheit (5) eingespeisten Speisespannung größer als oder gleich einer Schreibschwelle des nichtflüchtigen Speichers (11) wird, und
eine Schreibschaltung des nichtflüchtigen Speichers (11), die so angepasst ist, dass sie Daten, die in dem flüchtigen Speicher (10) gespeichert sind, in den nichtflüchtigen Speicher (11) schreibt, wenn das Schreibfreigabesignal ausgegeben ist, vorgesehen sind; und
der Betriebszustand der Funktionsschaltung (6) gemäß Informationen der Einstelldaten, geschrieben in dem flüchtigen Speicher (10), geschaltet ist.

4. Dreianschlussvorrichtung nach einem der Ansprüche 1 bis 3, **dadurch gekennzeichnet, dass**, nach Empfang der Einstelldaten für eine vorgegebene Zeitdauer oder entsprechend einer vorgegebenen Anzahl von Bits, die serielle Schnittstelle (8) so angepasst ist, dass sie die Schaltungshaupteinheit (5) in einen Eingabesperrzustand zurückversetzt, in dem Einstelldaten nicht eingebbar sind.

## Revendications

1. Dispositif à trois bornes, ayant
une unité principale de circuit (5) scellée par une matière de moulage et
trois bornes : une borne d'alimentation électrique (2), une borne de terre (3) et une borne entrée-sortie (4) qui connectent l'unité principale de circuit (5) et un circuit externe,
le dispositif à trois bornes étant **caractérisé en ce que**
l'unité principale de circuit (5) comprend :
un circuit fonctionnel (6) ;
un circuit de détection de salves (7) adapté pour détecter, à partir d'une borne prédéterminée parmi l'une quelconque des trois bornes, une salve d'activation d'écriture d'un signal de salve prescrit ayant une longueur qui est supérieure ou égale à un temps prescrit ;
des moyens d'autorisation de réception de données adaptés pour conduire l'unité principale de circuit (5) dans un état de validation d'entrée dans lequel des données de réglage peuvent être entrées quand la salve d'activation d'écriture est détectée ; et
des moyens d'enregistrement de données adaptés pour enregistrer, dans l'état de validation d'entrée, une entrée de données de réglage en provenance de la borne prédéterminée ;
dans lequel un état de fonctionnement du circuit fonctionnel (6) est réglé en fonction d'informations des données de réglage écrites dans les moyens d'enregistrement de données.

2. Dispositif à trois bornes selon la revendication 1, **caractérisé en ce que** les moyens d'autorisation de réception de données comprennent :
une interface série (8) adaptée pour recevoir une entrée de signal de données série en provenance de la borne prédéterminée ; et
un circuit de détection de modèle de signal (9) adapté pour détecter une entrée de signal modèle clé en provenance de la borne prédéterminée quand le circuit de détection de salves (7) détecte la salve d'activation d'écriture ;
dans lequel, quand le signal modèle clé est détecté, l'interface série (8) est adaptée pour recevoir des données de réglage entrées ensuite en provenance de la borne prédéterminée et pour écrire les données de réglage dans les moyens d'enregistrement de données.

3. Dispositif à trois bornes selon la revendication 1 ou 2, **caractérisé en ce que** les moyens d'enregistrement de données comprennent une mémoire volatile (10) et une mémoire non volatile (11) ;
l'interface série (8) reçoit l'entrée de données de réglage en provenance de la borne prédéterminée et écrit les données de réglage dans la mémoire volatile (10) ;
un circuit de détermination du niveau d'alimentation électrique adapté pour produire un signal de validation d'écriture quand un niveau d'une entrée de tension d'alimentation électrique dans une borne d'alimentation électrique (2) de l'unité principale de circuit (5) devient supérieur ou égal à un seuil d'écriture de la mémoire non volatile (11) et
il est fourni un circuit d'écriture dans une mémoire non volatile (11) adapté pour écrire des données, enregistrées dans la mémoire volatile (10), dans la mémoire non volatile (11) quand le signal de validation d'écriture est produit; et
ledit circuit fonctionnel (6) est commuté dans l'état de fonctionnement en fonction des informations des données de réglage écrites dans la mémoire volatile (10).

4. Dispositif à trois bornes selon l'une quelconque des revendications 1 à 3, **caractérisé en ce que**, lors de la réception des données de réglage pendant un temps prédéterminé ou correspondant à un nombre prédéterminé de bits, l'interface série (8) est adaptée pour replacer l'unité principale de circuit (5) dans un état invalidé pour l'entrée dans lequel des données de réglage ne peuvent pas être entrées.
